Europäisches Patentamt

European Patent Office

Office européen des brevets

(11) Numéro de publication : **0 512 884 B1**

## (12) FASCICULE DE BREVET EUROPEEN

(45) Date de publication du fascicule du brevet :
**13.04.94 Bulletin 94/15**

(51) Int. Cl.⁵ : **C11D 7/50,** C23G 5/028

(21) Numéro de dépôt : **92401165.3**

(22) Date de dépôt : **23.04.92**

(54) **Composition à base de 1,1-dichloro-1-fluoroéthane, de 1,1,1,3,3-pentafluorobutane et de méthanol, pour le nettoyage et/ou le séchage de surfaces solides.**

(30) Priorité : **02.05.91 FR 9105396**

(43) Date de publication de la demande :
**11.11.92 Bulletin 92/46**

(45) Mention de la délivrance du brevet :
**13.04.94 Bulletin 94/15**

(84) Etats contractants désignés :
**AT BE CH DE DK ES FR GB GR IT LI LU NL PT SE**

(56) Documents cités :
**EP-A- 0 325 265**
**EP-A- 0 381 986**
**WO-A-89/10984**
**US-A- 4 950 364**

(73) Titulaire : **ELF ATOCHEM S.A.**
**4 & 8, Cours Michelet La Défense 10**
**F-92800 Puteaux (FR)**

(72) Inventeur : **Michaud, Pascal**
**35 Boulevard Pasteur**
**F-95210 Saint-Gratien (FR)**

(74) Mandataire : **Leboulenger, Jean et al**
**Elf Atochem S.A. Département Propriété**
**Industrielle, Cedex 42 - La Défense 10**
**F-92091 Paris la Défense (FR)**

EP 0 512 884 B1

## Description

La présente invention concerne le domaine des hydrocarbures fluorés et chlorofluorés. Elle a plus particulièrement pour objet une nouvelle composition présentant un azéotrope et utilisable dans les applications de séchage, nettoyage, dégraissage et nettoyage à sec de surfaces solides, en particulier dans le défluxage et le nettoyage à froid de circuits imprimés.

Le 1,1,2-trichloro-1,2,2-trifluoroéthane (connu dans le métier sous la désignation F113) est largement utilisé dans l'industrie pour le nettoyage et le dégraissage des surfaces solides. Outre son application en électronique au nettoyage des flux de soudure pour éliminer le flux décapant qui adhère aux circuits imprimés, on peut mentionner ses applications au dégraissage de pièces métalliques lourdes et au nettoyage de pièces mécaniques de haute qualité et de grande précision comme, par exemple, les gyroscopes et le matériel militaire ou aérospatial. Dans ses diverses applications, le F113 est le plus souvent associé à d'autres solvants organiques (par exemple le méthanol), de préférence sous forme de mélanges azéotropiques ou pseudo-azéotropiques qui ne démixent pas et qui, employés au reflux, ont sensiblement la même composition dans la phase vapeur que dans la phase liquide.

Cependant, le F113 fait partie des chlorofluorocarbures complètement halogénés qui sont actuellement suspectés d'attaquer ou de dégrader l'ozone stratosphérique.

Dans la demande de brevet EP-A-0 381 986 qui concerne plus particulièrement l'utilisation de $C_3$- à $C_5$-polyfluoroalcanes en remplacement des chlorofluorocarbures habituellement utilisés comme gaz propulseurs dans des aérosols et pour la fabrication de mousses de polymères, il est sommairement indiqué que ces mêmes polyfluorocarbures peuvent aussi être employés comme agents de dégraissage et/ou de nettoyage et peuvent à cet effet être utilisés seuls ou en mélange avec des agents habituels de dégraissage et de nettoyage.

La demande de brevet WO-A-89 10984 décrit des compositions pseudo-azéotropiques à base de 1,1-dichloro-1-fluoroéthane et de méthanol, utilisables comme agents de dégraissage et de nettoyage.

Le brevet US 4 950 364 indique que le 1,1-dichloro-1-fluoroéthane et le 1,1,1,3,3-pentafluorobutane forment un azéotrope et a pour objet un procédé de séparation de ces deux composés.

La présente invention propose maintenant de remplacer les compositions à base de F113 par une nouvelle composition à base 1,1,1,3,3-pentafluorobutane, de méthanol et de 1,1-dichloro-1-fluoroéthane. Ce dernier composé, connu dans le métier sous la désignation F141b, est pratiquement dépourvu d'effet destructeur vis-à-vis de l'ozone. Il en est de même du 1,1,1,3,3-pentafluorobutane, connu dans le métier sous la désignation F365 mfc.

La composition à utiliser selon l'invention comprend de 60 à 90 % en poids de F141b, de 9 à 33 % de F365 mfc, et de 1 à 7 % de méthanol. Dans ce domaine, il existe un azéotrope dont la température d'ébullition est de 29,1°C à la pression atmosphérique normale (1,013 bar) et la composition selon l'invention a un comportement pseudo-azéotropique, c'est-à-dire que la composition des phases vapeur et liquide est sensiblement la même, ce qui est particulièrement avantageux pour les applications visées. De préférence, la teneur en F141b est choisie entre 75 et 82 % en poids, celle du F365 mfc entre 15 et 21 % en poids, et celle de méthanol entre 3 et 4 % en poids.

La composition selon l'invention a en outre l'avantage important de ne pas présenter de point éclair dans les conditions standard de détermination (norme ASTM-D 3828) ; la composition est donc ininflammable.

L'azéotrope F141b/F365 mfc/méthanol est un azéotrope positif puisque son point d'ébullition (29,1°C) est inférieur à ceux des constituants (F141b : 32°C ; F365 mfc : 40°C ; méthanol : 65°C).

Comme dans les compositions connues à base de F113, la composition selon l'invention peut être avantageusement stabilisée contre l'hydrolyse et/ou les attaques radicalaires susceptibles de survenir dans les processus de nettoyage, en y ajoutant un stabilisant usuel tel que, par exemple, un nitroalcane, la proportion de stabilisant pouvant aller de 0,01 à 5 % par rapport au poids total : F141b + F365 mfc + méthanol.

La composition selon l'invention peut être utilisée dans les mêmes applications et selon les mêmes techniques que les compositions antérieures à base de F113.

Les exemples suivants illustrent l'invention sans la limiter.

### EXEMPLE 1 : MISE EN EVIDENCE DE L'AZEOTROTE

Dans le bouilleur d'une colonne à distiller (30 plateaux), on introduit 100 g de F365 mfc, 100 g de méthanol et 100 g de F141b. Le mélange est ensuite mis à reflux total pendant une heure pour amener le système à l'équilibre. Au palier de température (29,1°C), on prélève une fraction (environ 50 g) qu'on analyse par chromatographie en phase gazeuse.

L'examen des résultats, consignés dans le tableau suivant, indique la présence d'un azéotrope F141b/F365 mfc/méthanol.

| | COMPOSITION (% poids) | | |
|---|---|---|---|
| | F141b | F365 mfc | Méthanol |
| Mélange initial | 33,3 | 33,3 | 33,4 |
| Fraction prélevée | 79,5 | 17,1 | 3,4 |

## EXEMPLE 2 : VERIFICATION DE LA COMPOSITION AZEOTROPIQUE

Dans le bouilleur d'une colonne à distiller adiabatique (30 plateaux), on introduit 200 g d'un mélange contenant en poids 79,5 % de F141b, 17,1 % de F365 mfc, et 3,4 % de méthanol. Le mélange est ensuite porté à reflux pendant une heure pour amener le système à l'équilibre, puis on soutire une fraction d'environ 50 g et on procède à son analyse par chromatographie en phase gazeuse ainsi qu'à celle du pied de distillation. Les résultats consignés dans le tableau suivant montrent la présence d'un azéotrope positif puisque son point d'ébullition est inférieur à ceux des constituants purs : F141b, F365 mfc , méthanol.

| | COMPOSITION (% poids) | | |
|---|---|---|---|
| | F141b | F365 mfc | Méthanol |
| Mélange initial | 79,5 | 17,1 | 3,4 |
| Fraction recueillie | 79,5 | 17,1 | 3,4 |
| Pied de distillation | 79,5 | 17,1 | 3,4 |
| Température d'ébullition corrigée pour 1,013 bar : 29,1°C | | | |

Cet azéotrope, employé pour le nettoyage de flux de soudure ou en dégraissage de pièces mécaniques, donne de bons résultats.

## EXEMPLE 3 : COMPOSITION STABILISEE AU NITROMETHANE

Dans une cuve de nettoyage à ultra-sons, on introduit 150 g d'un mélange contenant en poids 79,4 % de F141b, 17,1 % de F365 mfc, 3,4 % de méthanol et 0,1 % de nitrométhane comme stabilisant. Après avoir mis le système à reflux pendant une heure, on prélève un aliquat de la phase vapeur. Son analyse par chromatographie en phase gazeuse montre la présence de nitrométhane ce qui indique que le mélange est stabilisé dans la phase vapeur.

| | COMPOSITION (% poids) | | | |
|---|---|---|---|---|
| | F141b | F365 mfc | Méthanol | $CH_3NO_2$ |
| Mélange initial | 79,4 | 17,1 | 3,4 | 0,1 |
| Phase vapeur | 79,5 | 17,1 | 3,39 | 0,01 |

**EXEMPLE 4 : NETTOYAGE DE FLUX DE SOUDURE**

Dans une cuve à ultra-sons Annemasse, on introduit 200 g de la composition azéotropique F141b/F365 mfc/méthanol, puis on porte le mélange à la température d'ébullition.

Des circuits normalisés (modèle IPC-B-25), enduits de flux de soudure et recuits à l'étuve pendant 30 secondes à 220°C, sont plongés durant 3 minutes dans le liquide à l'ébullition sous ultra-sons, puis rincés dans la phase vapeur pendant 3 minutes.

Après séchage à l'air, une visualisation en lumière rasante revèle l'absence totale de résidu de flux de soudure. On a ainsi obtenu le même résultat qu'avec une composition F113-méthanol (93,7 %-6,3 %).

**Revendications**

1. Composition comprenant en poids de 60 à 90 % de 1,1-dichloro -1-fluoroéthane, de 9 à 33 % de 1,1,1,3,3-pentafluorobutane, et de 1 à 7 % de méthanol.

2. Composition selon la revendication 1 contenant en poids de 75 à 82 % de 1,1-dichloro-1-fluoroéthane, de 15 à 21 % de 1,1,1,3,3-pentafluorobutane, et de 3 à 4 % de méthanol.

3. Composition selon la revendication 2 sous forme d'azéotrope bouillant à 29,1°C à la pression normale.

4. Composition selon l'une des revendications 1 à 3, comprenant en outre au moins un stabilisant.

5. Composition selon la revendication 4, dans laquelle le stabilisant est un nitroalcane.

6. Composition selon la revendication 4 ou 5, dans laquelle la proportion de stabilisant est de 0,01 à 5 % par rapport au poids total du mélange : 1,1-dichloro-1-fluoroéthane + 1,1,1,3,3-pentafluorobutane + méthanol.

7. Application d'une composition selon l'une des revendications 1 à 6 au nettoyage et/ou au séchage des surfaces solides.

8. Application selon la revendication 7 au défluxage des circuits imprimés et au dégraissage des pièces mécaniques.

**Patentansprüche**

1. Zusammensetzung, die 60 bis 90 Gew.% 1,1-Dichlor-1-fluorethan, 9 bis 33 % 1,1,1,3,3-Pentafluorbutan und 1 bis 7 % Methanol enthält.

2. Zusammensetzung nach Anspruch 1, die 75 bis 82 Gew.% 1,1-Dichlor-1-fluorethan, 15 bis 21 % 1,1,1,3,3-Pentafluorbutan und 3 bis 4 % Methanol enthält.

3. Zusammensetzung nach Anspruch 2, die als Azeotrop unter Normaldruck bei 29,1°C siedet.

4

4. Zuzammensetzung nach einem der Ansprüche 1 bis 3, die zusätlich mindestens einen Stabilisator enthält.

5. Zuzammensetzung nach Anspruch 4, in der der Stabilisator ein Nitroalkan ist.

6. Zuzammensetzung nach Anspruch 4 oder 5, in der der Anteil des Stabilisators bezogen auf das Gesamtgewicht von 1,1-Dichlor-1-fluorethan, 1,1,1,3,3-Pentafluorbutan und Methanol 0,01 bis 5 Gew.% beträgt.

7. Verwendung einer Zuzammensetzung nach einem der Ansprüche 1 bis 6 zum Reinigen und/oder Trocknen von harten Oberflächen.

8. Verwendung nach Anspruch 7 zur Flussmittelentfernung von gedruckten Schaltungen und zur Entfettung von Maschinenteilen.

## Claims

1. Composition comprising, on a weight basis, from 60 to 90 % of 1,1-dichloro-1-fluoroethane, from 9 to 33 % of 1,1,1,3,3-pentafluorobutane and from 1 to 7 % of methanol.

2. Composition according to Claim 1, containing, on a weight basis, from 75 to 82 % of 1,1-dichloro-1-fluoroethane, from 15 to 21 % of 1,1,1,3,3-pentafluorobutane and from 3 to 4 % of methanol.

3. Composition according to Claim 2 in the form of an azeotrope boiling at 29.1°C at normal pressure.

4. Composition according to one of Claims 1 to 3, additionally comprising at least one stabilizer.

5. Composition according to Claim 4, in which the stabilizer is a nitroalkane.

6. Composition according to Claim 4 or 5, in which the proportion of stabilizer is from 0.01 to 5 % relative to the total weight of the mixture: 1,1-dichloro-1-fluoroethane + 1,1,1,3,3-pentafluorobutane + methanol.

7. Application of a composition according to one of Claims 1 to 6 to the cleaning and/or drying of solid surfaces.

8. Application according to Claim 7 to the defluxing of printed circuits and to the degreasing of mechanical components.